(19) Europäisches Patentamt
European Patent Office
Office européen des brevets

(11) Numéro de publication: **0 151 895**
**B1**

(12) **FASCICULE DE BREVET EUROPEEN**

(45) Date de publication du fascicule du brevet: **18.05.88**

(51) Int. Cl.⁴: **G 01 R 33/032**

(21) Numéro de dépôt: **84402748.2**

(22) Date de dépôt: **27.12.84**

(54) **Procédé de mesure magnéto-optique de champs magnétiques, système de mesure, et cellule de mesure utilisant un tel procédé.**

(30) Priorité: **27.01.84 FR 8401289**

(43) Date de publication de la demande:
**21.08.85 Bulletin 85/34**

(45) Mention de la délivrance du brevet:
**18.05.88 Bulletin 88/20**

(84) Etats contractants désignés:
**DE GB IT**

(58) Documents cités:
**EP-A-0 081 412**
**FR-A-2 198 146**

(73) Titulaire: **THOMSON-CSF**
**173, Boulevard Haussmann**
**F-75379 Paris Cédex 08 (FR)**

(72) Inventeur: **Doriath, Gérard**
**THOMSON-CSF SCPI 173, bld Haussmann**
**F-75379 Paris Cedex 08 (FR)**
Inventeur: **Hartemann, Pierre**
**THOMSON-CSF SCPI 173, bld Haussmann**
**F-75379 Paris Cedex 08 (FR)**
Inventeur: **Jacobelli, Alain**
**THOMSON-CSF SCPI 173, bld Haussmann**
**F-75379 Paris Cedex 08 (FR)**

(74) Mandataire: **Lepercque, Jean et al**
**THOMSON-CSF SCPI 19, avenue de Messine**
**F-75008 Paris (FR)**

**EP 0 151 895 B1**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

Courier Press, Leamington Spa, England.

**Description**

L'invention concerne un procédé de mesure magnéto-optique de champs magnétiques. Elle concerne également un système de mesure, ou magnétomètre, mettant en oeuvre ce procédé ainsi qu'une cellule de mesure adaptée à ce système.

On sait mesurer avec précision la valeur d'un champ magnétique en un point donné. Cette exigence de précision conduit à concevoir des appareils d'une sensibilité telle que leurs mesures peuvent être affectées par les fluctuations du champ magnétique ambiant. C'est ainsi par exemple que certains magnétomètres permettent de mesurer de faibles champs magnétiques de l'ordre du nano-Tesla alors qu'il est courant que le champ magnétique ambiant présente des amplitudes de variations atteignant quelques dizaines à quelques centaines de nano-Teslas dans un spectre de fréquences s'étendant du continu à quelques dizaines de Hertz.

Pour effectuer des mesures de champs magnétiques précises et pouvoir les corriger en fonction du champ magnétique ambiant, on a la possibilité d'utiliser plusieurs magnétomètres. On doit alors prendre des précautions pour que ces magnétomètres n'agissent pas les uns sur les autres.

La demande de brevet français N° 2 471 608 publié le 13 août 1982, la première addition N° 2 517 831 à cette demande de brevet publiée le 10 juin 1983 ainsi que la demande de brevet N° 83 110 73 déposée le 4 juillet 1983 décrivent des magnétomètres dont la cellule commune de base est constituée d'une source de lumière polarisée, d'une couche mince possédant un effet magnétooptique important, d'un analyseur et d'un système de détection et de conversion lumière-courant électrique. A ces éléments s'ajoutent un solenoïde de modulation et de contre-réaction ainsi qu'une paire de bobines ou d'aimants de saturation créant un champ magnétique de polarisation.

Quand plusieurs magnétomètres sont employés dans un volume réduit, c'est le cas pour la mesure triaxe, ou quand les cellules de bases sont utilisées pour la mesure de vecteurs de gradient de champ magnétique la sensibilité de la mesure est affectée par l'existence des champs magnétiques continu de polarisation qui déforme mutuellement les lignes de champs magnétiques. Aussi, les hommes de l'art essaient-ils de réduire ou d'éliminer ces champs magnétiques continus de polarisation.

L'invention fournit une solution permettant d'éliminer le champ magnétique de polarisation du magnétomètre. Elle présente de plus l'avantage de fonctionner avec une cellule de magnétomètre de conception simplifiée et d'encombrement réduit.

L'invention a donc pour objet un procédé de mesure de champ magnétique utilisant une couche d'un matériau ferrimagnétique dans laquelle on fait circular, selon un axe déterminé, un faisceau lumineux polarisé selon un plan déterminé de telle façon qu'un champ magnétique orienté selon l'axe du faisceau ait un effet de rotation par effet Faraday du plan de polarisation de la lumière cactérisé en ce qu'il comporte: une première étape d'induction dans la couche de matériau ferrimagnétique, selon l'axe du faisceau lumineux, d'un champ magnétique de modulation alternatif d'amplitude supérieure à la limite de saturation de la couche de matériau ferrimagnétique et celà durant un temps suffisant pour entretenir une oscillation cohérente de l'aimantation dans la couche de matériau ferrimagnétique donnant lieu à une oscillation du plan de polarisation du faisceau lumineux, symétrique par rapport audit plan déterminé; et une deuxième étape comprenant les opérations suivantes exécutées simultanément:

diminution progressive de l'intensité du champ de modulation,

détection de toute dissymétrie de l'oscillation du plan de polarisation du faisceau lumineux par rapport audit plan déterminé,

inducation selon l'axe du faisceau lumineux, d'un champ magnétique correspondant à la détection réalisée et ayant pour rôle de rétablir la symétrie de l'oscillation.

L'invention a également pour objet un système de mesure, mettant en oeuvre le procédé précédent, comportant un dispositif d'émission permettant d'émettre un faisceau lumineux polarisé linéairement se propageant suivant un axe de propagation déterminé; une plaquette en matériau magnétique, alignée selon l'axe du faisceau de lumière et permettant, en son sein, une propagation guidée du fasceau ainsi qu'une rotation de la direction de polarisation du faisceau pendant sa propagation; des moyens de mesure de rotation de polarisation associé à la plaquette selon l'axe du faisceau lumineux, recevant le faisceau après traversée de la plaquette associée et fournissant un signal de mesure de rotation de polarisation, caractérisé en ce qu'il comporte également un solénoïde placé autour de la plaquette de façon à pouvoir induire un champ magnétique selon l'axe du faisceau lumineux ainsi que des circuits de commande et d'alimentation permettant, durant un temps correspondant à la première étape, d'alimenter ledit solénoïde à l'aide d'un courant alternatif d'amplitude élevée de façon à ce que le champ induit sature la plaquette, puis durant un temps correspondant à la deuxième étape, de diminuer progressivement le niveau d'alimentation du solénoïde en courant alternatif, et de l'alimenter simultanément à l'aide d'un courant continu de contre réaction en fonction du signal de mesure de rotation de polarisation fourni par les moyens de mesure, pour permettre de contrebalancer un champ magnétique continu existant le long de l'axe du faisceau.

Enfin, l'invention a pour objet une cellule de mesure applicable dans le procédé et le système précédents. Cette cellule comporte notamment une couche de matériau ferrimagnétique d'une forme allongée et est disposée de telle façon que le faisceau lumineux la traverse selon sa petite

dimension, de telle façon que le champ démagnétisant soit perpendiculaire à la direction du faisceau lumineux.

L'invention sera mieux comprise et d'autres caractéristiques apparaîtront à l'aide de la description qui suit faite en référence aux figures annexées parmi lesquelles:

la figure 1 représente un magnétomètre selon l'art connu,

la figure 2 représente un magnétomètre selon l'invention,

la figure 3 représente un exemple de réalisation d'une cellule de magnétomètre selon l'invention.

Dans la description qui va suivre on désignera par magnétomètre l'ensemble du système permettant de faire des mesures de champ magnétique, ce système englobant le dispositif sensible au champ magnétique ainsi que les circuits d'alimentation, de détection et de traitement. On désignera par cellule du magnétomètre le dispositif directement sensible au champ magnétique et que l'on peut déplacer lors des mesures indépendamment des circuits.

En se reportant à la figure 1, on va tout d'abord décrire un magnétomètre connu dans la technique.

Ce magnétomètre comprend une source laser à semiconducteur ou diode laser 1, un polariseur 2, une plaquette 3, un analyseur 4 et une diode photodétectrice 5, l'ensemble étant situé selon un plan yOz, ainsi que des circuits d'alimentation et de détection 10 et 11. La plaquette 3 est placée à l'intérieur d'un bobinage de modulation 6 et d'un bobinage de compensation 7 tous deux concentriques. Deux pièces polaires 8 et 9 situées de part et d'autre de la plaquette 3 induisent un champ magnétique continu dans la plaquette 20 selon le plan principal de la plaquette et transverse à la direction de propagation de la lumière dans la plaquette.

La diode laser l'émet à partir de l'une de ses faces un faisceau lumineux F1 collimaté. La surface de la face d'émission a typiquement pour dimensions 0,2 micron par 15 microns. Une telle diode est alimentée par une tension électrique déterminée.

La plaquette 3 est taillée dans un grenat de gadolinium et de gallium dit GGG. Sur la surface de GGG on a fait pousser par épitaxie une couche relativement épaisse de YIG répondant sensiblement à la composition

$$Gd_{0,45}\, Y_{2,55}\, Ga_{0,9}\, Fe_{4,1}\, O_{12}.$$

L'épaisseur obtenue peut être comprise entre 5 et 110 microns et une valeur typique est de 20 microns.

Une telle épaisseur de YIG permet de faire propager la lumière de manière guidée mais multimode, et dans ces conditions l'effet Faraday dû au champ magnétique se manifeste uniquement par une rotation du plan de polarisation de la lumière et non plus par une conversion du mode TM en mode TE. Ceci permet de coupler le faisceau lumineux par les faces terminales de la couche YIG. Dans la description qui va suivre on considèrera dans l'utilisation de la plaquette 3, le rôle fonctionnel de la couche de YIG.

On va maintenant décrire le fonctionnement du magnétomètre de la figure 1.

La diode laser 1 est alimentée par ses bornes d'entrée à l'aide d'une source appropriée non représentée. Elle fournit un faisceau lumineux F1 d'une puissance de quelques milliwatts à la longueur d'onde de 1,3 microns. Après traversée du polariseur 2, le faisceau F1 est couplé à la plaquette 3 par la face d'entrée 60. La plaquette 3 joue le rôle de guide d'onde. Le champ magnétique à mesurer a pour effet d'induire, dans la plaquette 3, un effet Faraday qui se manifeste par une rotation du plan de polarisation de la lumière. Cette rotation est proportionnelle à l'intensité de la composante du champ magnétique selon la direction de propagation de la lumière, c'est-à-dire l'axe Oz. On a donc intérêt à orienter l'ensemble de la tête de mesure représentée en figure 1 dans le champ magnétique à mesurer de telle façon que le faisceau F1 soit dirigé selon les lignes de ce champ magnétique.

Par ailleurs, pour obtenir une détection optimale, il est nécessaire que le vecteur aimantation soit sans le plan de la couche, et qu'en absence de champ magnétique à détecter suivant la direction de la propagation lumineuse, il soit normal à celle-ci. La couche est saturée suivant cet axe au moyen des pièces polaires 8 et 9 ou de bobines en configuration d'Helmotz. La valeur de ce champ magnétique de saturation est inférieure à 1 oersted. La composante du champ magnétique suivant l'axe de propagation de la lumière a pour effet de désorienter cette aimantation et de provoquer une rotation du plan de polarisation de la lumière. Les effets mis en jeu ne sont pas linéaires et rendent difficile la mesure directe du champ magnétique.

La rotation du plan de polarisation de la lumière n'étant pas une fonction linéaire du champ magnétique à mesurer le long de la direction de propagation du faisceau F1 (axe Oz), il est difficile de traduire le résultat de mesure obtenu sur la sortie 55 en valeur de champ magnétique mesuré. On utilise donc un méthode de zéro. Pour cela, un circuit d'alimentation et de commande 11 alimente le bobinage d'excitation 6 à l'aide d'un courant alternatif par les connexions d'entrée E60 et E61. Le bobinage 6 induit dans la plaquette 3 un champ magnétique alternatif parallèle à la direction de propagation du faisceau F1, c'est-à-dire selon l'axe Oz, et donc parallèle au champ à mesurer. Celui-ci est modulé par le champ alternatif fournit par le bobinage 6. L'intensité de la lumière détectée par la diode photodétectrice 5 est donc modulée. En l'absence de champ magnétique à mesurer, l'intensité de la lumière varie selon une loi ne contenant que des harmoniques paires du signal d'excitation appliqué au bobinage 6. La présence d'un champ magnétique à mesurer selon l'axe Oz donne lieu à l'apparition d'harmoniques impaires. L'amplitude du fondamental varie en fonction de la valeur du champ à mesurer.

Lorsque la plaquette 3 est soumise à un champ magnétique à mesurer orienté selon l'axe Oz, la

diode photodétectrice 5 détecte le signal lumineux, transmet un signal électrique de forme équivalente sur sa sortie 55 vers l'amplificateur 10 qui le retransmet sur sa sortie 51 vers le circuit d'alimentation et de commande 11. Celui-ci détecte les harmoniques impaires et commande l'alimentation en courant continu du bobinage de compensation 7 par les connexions d'entrée E70 et E71.

Le bobinage 7 induit dans la plaquette 3, un champ magnétique continu selon la direction du faisceau lumineux, c'est-à-dire selon la direction du champ à mesurer. En réglant la valeur du courant continu en sens et en amplitude de façon appropriée telle que le champ continu induit compense le champ à mesurer, celui-ci n'a plus d'effet sur la rotation du plane de polarisation du faiseau lumineux F1. Il suffit alors de mesurer la valeur du courant continu fourni au bobinage 7 pour en déduire la valeur du champ mesuré.

Le magnétomètre de la figure 1 a donc permis de mesurer un champ magnétique.

Cependant, il arrive qu'on ait besoin de disposer plusieurs cellules de mesure de magnétomètres proches les unes des autres pour dresser une carte du magnétisme en un point donné par exemple. L'utilisation de magnétomètres tel que celui décrit précédemment présente l'inconvénient que les pièces polaires 8 et 9 des différents magnétomètres induisent des champs magnétiques pouvant perturber les mesures des autres magnétomètres.

L'invention fournit un procédé de mesure et un magnétomère mettant en oeuvre ce procédé, permettant de s'affranchir du champ magnétique produit par les pièces polaires 8 et 9. De plus, le magnétomètre selon l'invention présente l'avantage d'être de dimensions réduites.

La figure 2 représente un magnétomètre selon l'invention.

Ce magnétomètre comporte une diode laser 1, un polariseur 2, une plaquette 3 de constitution identique à celle décrite en relation avec la figure 1, un analyseur 4, une diode photodétectrice 5, un solénoïde 12 selon l'axe duquel est placée la plaquette 3, un amplificateur 10, un détecteur 15, des circuits de commande de d'alimentation 11, 13 et 14.

Comme dans le magnétomètre de la figure 1, la diode laser l'émet un faisceau lumineux F1 qui est polarisé par le polariseur 2 et est transmis par la plaquette 3 et l'analyseur 4 à la diode photodétectrice 5.

Le procédé de l'invention prévoit d'induire, durant un premier intervalle de temps t1, un champ magnétique alternatif de modulation saturant la couche selon la direction de propagation de la lumière ce qui engendre une rotation cohérente de l'aimantation. Celle-ci oscille autour de son axe de symétrie qui est perpendiculaire à la direction de propagation de la lumière. Le plan de polarisation de la lumière oscille également de manière symétique.

A l'issue de ce temps t1, lorsque le phénomène d'oscillation est établi de manière stable, le procédé de l'invention prévoit de diminuer progressivement l'amplitude du champ magnétique alternatif de modulation. Lorsque le champ magnétique devient inférieur à la limite de saturation de la plaquette 3, un champ continu à mesurer, orienté selon la direction de propagation de la lumière, est mis en évidence par la dissymétrie de l'oscillation du plan de polarisation. Cette dissymétrie est d'autant plus perceptible que l'on diminue l'amplitude du champ magnétique alternatif de modulation.

Dans ces conditions, pendant que l'on diminue l'amplitude du champ magnétique alternatif de modulation et dès que l'on constate une dissymétrie dans l'oscillation du plan de polarisation du faisceau F1, on induit un champ magnétique de contre-réaction ayant pour effet de contrebalancer l'effet du champ magnétique à mesurer. Au fur et à mesure que la champ magnétique de modulation diminue, le système devient plus sensible et on peut ajuster la valeur du champ magnétique de contre-réaction à une valeur annulant avec précision l'effet du champ à mesurer.

Le magnétomètre de la figure 2 fonctionnera donc de la manière suivante.

Un circuit de base de temps 13 est mis en fonctionnement sous la commande d'un signal C1 fourni soit manuellement, soit au moyen d'un dispositif non représenté. Le circuit de base de temps fournit un signal t1 de durée déterminée à l'entrée E34 du circuit d'alimentation 11. Celui-ci, en réponse, fournit, sur ces sorties E30 et E31, un courant alternatif alimentant le solénoïde 12. Le courant alternatif est d'une amplitude telle qu'un champ magnétique de modulation induit par le solénoïde 12 dans la plaquette 3 a pour effet de saturer la plaquette.

Un faisceau lumineux émis par la diode laser 1, polarisé par le polariseur 2 et traversant la plaquette 3, a donc son plan de polarisation qui oscille sous l'effet du champ magnétique de modulation. La diode 5 recueille un faisceau lumineux dont la luminosité oscille de façon régulière.

Au terme du temps t1, le circuit de base de temps 13 cesse de fournir le signal t1 et fournit un signal t2 à l'entrée E35 du circuit d'alimentation 11. Celui-ci commande la diminution régulière de l'amplitude du courant alternatif fournit sur les sorties E30 et E31 et donc du champ magnétique de modulation.

Le signal t2 est également fournit à un circuit à porte 14 de façon à le rendre passant.

S'il existe un champ magnétique continu ou lentement variable ou une composante d'un tel champ magnétique dirigé le long de la direction de propagation du faisceau lumineux, lorsque le champ magnétique de modulation diminue suffisamment, la diode photodétectrice 5 détecte un signal comporte des harmoniques impaires. Ce signal est amplifié par l'amplificateur 10 qui le retransmet au détecteur 15. Celui-ci détecte les harmoniques impaires et fournit un signal de commande CR1 au circuit à porte 14. Ce circuit à porte étant passant, un signal de commande CR2

est appliqué à l'entrée E36 du circuit d'alimentation. Le circuit d'alimentation 11 fournit entre ses sorties E32 et E33 un courant de contre-réaction dont l'amplitude est fonction du signal de commande CR2. Ce courant alimente le solénoïde 12 et a pour rôle d'induire un champ magnétique qui contre-balance l'effet du champ magnétique détecté.

Pendant ce temps, le courant alternatif, fourni sur les sorties E30 et E31 par le circuit d'alimentation 11, continu à diminuer. La sensibilité du système augmente donc et le détecteur 15 peut détecter des harmoniques impaires correspondant à un signal à détecter plus faible comptetenu du courant de contre-réaction fourni au solénoïde. Le processus continu ainsi jusqu'à ce que l'amplitude du courant alternatif atteigne une valeur correspondant à la sensibilité que l'on désire obtenir.

La valeur du courant de contre-réaction, fourni au solénoïde 12 pour contrebalancer le champ magnétique à mesurer, est affichée sur un appareil de mesure 16. Cet appareil, convenablement gradué fournit la valeur du champ magnétique de contre-réaction et donc du champ à mesurer.

Il est à noter que les sorties E30 et E32 d'une part et E31 et E33 sont découplées par des moyens non représentés.

Le temps t1 durant lequel est fourni un champ de modulation d'inten sité élevée sera de l'ordre de 1 seconde par exemple.

Par ailleurs, pour améliorer le fonctionnement du magnétomètre, l'invention prévoit également de donner à la plaquette 3 une forme allongée telle que l'axe de l'aimentation dû au champ démagnétisant, créé naturellement par le matériau, soit perpendiculaire à la direction de propagation de la lumière. La longueur et la largeur de la plaquette seront par exemple dans un rapport de 5 et la plaquette sera disposée sur le trajet du faisceau lumineux de telle façon qu'elle soit traversée selon sa largeur par le faisceau lumineux F1. Dans ces conditions, lorsque le champ de modulation prendra une valeur faible, l'oscillation de ce champ se fera de préférence de façon symétrique par rapport à la direction du champ de démagnétisation, et celà notamment en l'absence de champ à mesurer le long de la direction de propagation du faisceau lumineux.

De plus, les composantes de champs magnétiques perpendiculaires à l'axe de la lumière auront un effet coopératif avec le champ démagnétisant pour maintenir l'oscillation de l'aimantation symétrique. La cohérence et la symétrie de l'oscillation étant assurées ainsi, il suffit de diminuer l'amplitude du champ de modulation pour avoir le maximum de sensibilité.

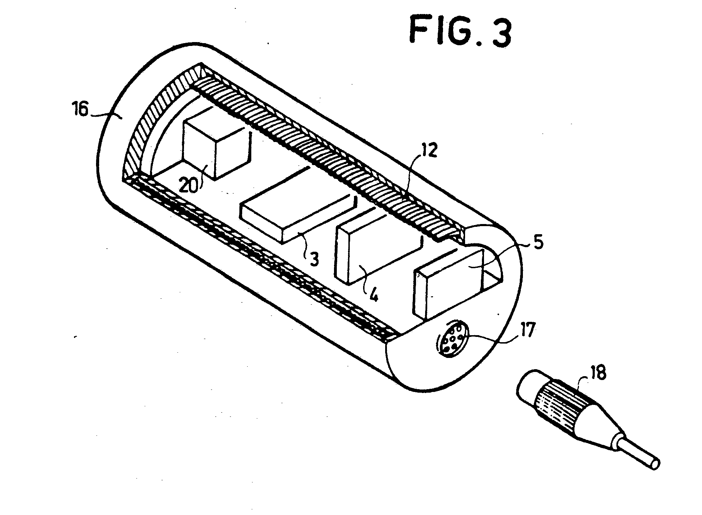

La figure 3 représente un exemple de réalisation d'une cellule de magnétomètre réalisée conformément à l'invention.

On retrouve sur cette figure une diode laser 20, la plaquette 3, l'analyseur 4, la diode photodétectrice 5, le solénoïde 12.

La diode 20 est une diode semiconductrice qui émet un faisceau polarisé. C'est pourquoi on ne retrouve pas le polariseur 2 de la figure 2.

La plaquette 3, selon cet exemple de réalisation à 20 mm de longueur sur 5 mm de largeur.

L'ensemble est monté dans un boîtier 16 de forme générale cylindrique de 30 mm de diamètre et de 45 mm de longueur environ.

Les circuits de commande et d'alimentation (11, 13, 14) ainsi que les circuits de détection (10, 15) ne sont pas représentés sur la figure 3. Ils sont connectables à la cellule du magnétomètre et notamment aux diodes 20, 5 et au solénoïde 12 par un connecteur 17 prévu dans le boîtier 16 et d'une prise enfichable 18.

Il apparaît donc que la construction d'une telle sonde est particulièrement simple. De plus, la simplicité de la structure permet d'envisager aisément une sonde de très petite dimension.

**Revendications**

1. Procédé de mesure de champ magnétique utilisant une couche (3) d'un matériau ferrimagnétique dans laquelle on fait circuler, selon un axe déterminé, un faisceau lumineux polarisé selon un plan déterminé de telle façon qu'un champ magnétique orienté selon l'axe du faisceau ait un effet de rotation par effet Faraday du plan de polarisation de la lumière, caractérisé en ce qu'il comporte: une première étape d'induction dans la couche de matériau ferrimagnétique, selon l'axe du faisceau lumineux, d'un champ magnétique de modulation alternatif d'amplitude supérieure à la limite de saturation de la couche (3) de matériau ferrimagnétique et celà durant un temps suffisant correspondant à un temps de stabilisation au bout duquel doit être établie une oscillation cohérente de l'aimantation dans la couche de matériau ferrimagnétique, laquelle oscillation donne lieu à une oscillation du plan de polarisation du faisceau lumineux, symétrique par rapport audit plan déterminé; et une deuxième étape comprenant les opérations suivantes exécutées simultanément:

diminution progressive de l'intensité du champ de modulation,

détection de toute dissymétrie de l'oscillation du plan de polarisation du faisceau lumineux par rapport audit plan déterminé,

induction selon l'axe du faisceau lumineux, d'un champ magnétique continu correspondant à la détection réalisée, avant pour rôle de rétablir la symétrie de l'oscillation, et permettant d'obtenir une valeur du champ magnétique à mesurer.

2. Système de mesure mettant en oeuvre le procédé de la revendication 1, comportant une cellule de mesure comprenant elle-même: un dispositif d'émission (1) permettant d'émettre un faisceau lumineux (F1) polarisé linéairement se propageant suivant un axe de propagation déterminé; une plaquette en matériau magnétique (3), alignée selon l'axe du faisceau de lumière et permettant, en son sein, une propagation guidée du faisceau ainsi qu'une rotation

de la direction de polarisation du faisceau pendant sa propagation; un analyseur (4); des moyens (5), de détection de rotation de polarisation associé à la plaquette (3) selon l'axe du faisceau lumineux, recevant le faisceau aprè traversée de la plaquette associée, et fournissant un signal de mesure de rotation de polarisation (CR1); et un solénoïde (12) placé autour de la plaquette de façon à pouvoir induire un champ magnétique selon l'axe du faisceau lumineux caractérisé en ce qu'il comporte des circuits de commande et d'alimentation (11, 13, 14) permettant durant un temps correspondant à la première étape, d'alimenter ledit solénoïde à l'aide d'un courant alternatif d'amplitude élevée de façon à ce que le champ induit sature la plaquette (3), puis durant un temps correspondant à la deuxième étape, de diminuer progressivement le niveau d'alimentation du solénoïde (12) en courant alternatif, et de l'alimenter simultanément à l'aide d'un courant continu de contre réaction en fonction du signal de mesure (CR1) de rotation de polarisation fourni par les moyens de détection (5, 10 et 15) pour permettre de contrebalancer un champ magnétique continu existant le long de l'axe du faisceau.

3. Système de mesure selon la revendication 2, caractérisé en ce que les circuits de commande et d'alimentation comportent: un circuit d'alimentation (11) possédant une première, une deuxième et une troisième entrées (E34, E35, E36) de commande et permettant d'alimenter en courant par des premières sorties (E30, E31) et des deuxièmes sorties (E32, E33) le solénoïde (12) selon les signaux reçus sur ses trois entrées; un circuit à porte (14) connecté à la troisième entrée (E36) du circuit d'alimentation et permettant de lui transmettre un signal de mesure de rotation de polarisation (CR2) reçu des moyens de détection (5, 10, 15); un circuit de base de temps (13) connectés aux première et deuxième entrées (E34, E35) du circuit d'alimentation (11) ainsi qu'au circuit à porte (14), fournissant durant un temps déterminé correspondant à la première étape, un premier signal (t1) sur la première entrée (E34) du circuit d'alimentation (11) pour commander par ses premières sorties (E30, E31) l'alimentation du solénoïde (12) à l'aide d'un courant alternatif de modulation de forte amplitude puis durant un temps correspondant à la deuxième étape, un deuxième signal (t2) d'une part sur la deuxième entrée (E35) du circuit d'alimentation (11) et commandant la diminution progressive du courant alternatif de modulation, et d'autre part au circuit à porte (14) de façon à le rendre passant et à permettre la transmission du signal de mesure de rotation de polarisation (CR1) à la troisième entrée (E36) du circuit d'alimentation (11) pour commander par celui-ci, par ses deuxièmes sorties (E32, E33) l'alimentation du solénoïde (12) à l'aide d'un courant de contre réaction induisant un champ magnétique annulant l'effet du champ magnétique à mesurer.

4. Cellule de mesure selon l'une quelconque des revendications 2 à 3 caractérisé en ce que la couche de matériau ferrimagnétique (3) a une forme allongée et qu'elle est disposée de telle façon que le faisceau lumineux (F1) la traverse selon sa petite dimension, le champ démagnétisant étant alors perpendiculaire à la direction du faisceau lumineux.

**Patentansprüche**

1. Verfahren zur Magnetfeldmessung unter Verwendung einer Schicht (3) aus ferrimagnetischem Material, worin ein Bündel polarisierten Lichts entlang einer bestimmten Achse zum Zirkulieren gebracht wird, wobei die Polarisation in einer Ebene liegt, die so bestimmt ist, daß ein entlang der Achse des Bündels orientiertes Magnetfeld einen auf dem Faraday-Effekt beruhenden Rotationseffekt auf die Polarisationsebene des Lichtes ausübt, dadurch gekennzeichnet, daß es umfaßt: eine erste Stufe, in welcher in die Schicht aus ferrimagnetischem Material und entlang der Achse des Lichtbündels ein magnetisches alternierendes Modulationsfeld mit einer Amplitude induziert wird, die größer als die Sättigungsgrenze der Schicht (3) aus ferrimagnetischem Material ist, und zwar während einer ausreichenden Zeit, die einer Stabilisierungszeit entspricht, nach deren Ablauf eine kohärente Schwingung der Magnetisierung in der Schicht aus ferrimagnetischem Material aufgebaut sein muß, wobei diese Schwingung zu einer Schwingung der Polarisationsebene des Lichtbündels führt, die symmetrisch in bezug auf die bestimmten Ebene ist; und einen zweiten Schritt enthält, der die folgenden, gleichzeitig ausgeführten Operationen umfaßt:

progressive Verminderung der Intensität des Modulationsfeldes,

Erfassung jeglicher Unsymmetrie der Schwingung der Polarisationsebene des Lichtbündels bezüglich der bestimmten Ebene,

entlang der Achse des Lichtbündels wird ein magnetisches Gleichfeld induziert, welches der durchgeführten Erfassung entspricht und dessen Funktion darin besteht, die Symmetrie der Schwingung wiederherzustellen, und es ermöglicht, einen Wert des zu messenden Magnetfeldes zu erhalten.

2. Meßsystem, bei welchem das Verfahren nach Anspruch 1 angewendet wird, mit einer Meßzelle, die ihrerseits enthält: eine Sendevorrichtung (1), die es ermöglicht, ein linear polarisiertes Lichtbündel (F1) auszusenden, welches sich entlang einer bestimmten Ausbreitungsachse ausbreitet; eine Platte aus magnetischem Material (3), welche entland der Achse des Lichtbündels ausgerichtet ist und in ihrem Inneren eine geführte Ausbreitung des Bündels sowie eine Drehung der Polarisationsrichtung des Bündels während seiner Ausbreitung ermöglicht; einen Analysator (4); Mittel (5) zur Erfassung der Polarisationsdrehung, welche der Platte (3) entlang der Achse des Lichtbündels zugeordnet sind und das Bündel nach Durchqueren der zugeordneten Platte empfangen sowie ein Polarisationsdrehungs-Meßsignal (CR1) liefern; und eine Magnetspule (12), welche um die Platte herum derart angeordnet ist, daß sie ein Magnetfeld entlang der Achse des Lichtbündels erzeugen kann, dadurch gekennzeichnet, daß es Steuer- und Speiseschaltungen (11, 13, 14) enthält, die es gestatten, während einer Zeit, die der ersten Stufe entspricht, die genannte Magnetspule mit einem Wechselstrom von hoher Amplitude zu speisen, so daß das induzierte Feld die Platte (3) sättigt, und während einer Zeit, die der zweiten Stufe entspricht, den Pegel der Speisung der Magnetspule (12) mit Wechselstrom progressive zu vermindern und sie gleichzeitig mit einem Rückkopplungs-Gleichstrom in Abhängigkeit von dem Polarisationsdrehungs-Meßsignal (CR1) zu speisen, welches die Detektionsmittel (5, 10 und 15) liefert, um einem entlang der Achse des Bündels vorhandenen magnetischen Gleichfeld das Gleichgewicht zu halten.

3. Meßsystem nach Anspruch 2, dadurch gekennzeichnet, daß die Steuer- und Speisekreise enthalten: einen Speisekreis (11), welcher einen ersten, einen zweiten und einen dritten Steuereingang (E34, E35, E36) enthält und es gestattet, die Magnetspule (12) mit den an seinen drei Eingängen empfangenen Signalen über erste Ausgänge (E30, E31) und über zweite Ausgänge (E32, E33) zu speisen; eine Torschaltung (14), welche mit dem dritten Eingang (E36) des Speisekreises verbunden ist und es gestattet, ihm ein Polarisationsdrehungs-Meßsignal (CR2) zuzuführen, welches von den Detektionsmitteln (5, 10, 15) erhalten wird; eine Zeitbasisschaltung (13), welche mit dem ersten und dem zweiten Eingang (E34, E35) des Speisekreises (11) sowie mit der Torschaltung (14) verbunden ist, um während einer bestimmten Zeit, die der ersten Stufe entspricht, ein Signal (t1) an den ersten Eingang (E34) des Speisekreises (11) zu liefern und über seine ersten Ausgänge (E30, E31) die Speisung der Magnetspule (12) mit einem Modulations-Wechselstrom von hoher Amplitude zu steuern, sowie während einer Zeitspannung, die der zweiten Stufe entspricht, ein Signal (t2) einerseits an den zweiten Eingang (E35) des Speisekreises (11) zu liefern, um die progressive Verminderung des Modulations-Wechselstromes zu steuern, und andererseits an die Torschaltung (14) liefert, so daß diese durchschaltet und die Übertragung des Polarisationsdrehungs-Meßsignals (CA1) zum dritten Eingang (E36) des Speisekreises (11) gestattet, damit diese über ihre zweiten Ausgänge (E32, E33) die Speisung der Magnetspule (12) mit einem Rückkopplungsstrom steuert, welcher ein Magnetfeld induziert, durch den die Wirkung des zu messenden Magnetfeldes zum Verschwinden gebracht wird.

4. Meßzelle nach einem der Ansprüche 2 und 3, dadurch gekennzeichnet, daß die Schicht aus ferrimagnetischem Material (3) eine gestreckte Form aufweist und daß sie derart angeordnet ist, daß sie das Lichtbündel (F1) entlang seiner kleinen Abmessung durchquert, wobei das entmagnetisierende Feld dann senkrecht zur Richtung des Lichtbündels gerichtet ist.

**Claims**

1. Method of measuring a magnetic field using a layer (3) of ferrimagnetic material wherein a light beam is caused to circulate along a determined axis, the light beam being polarized along a plane determined in such a manner that a magnetic field oriented along the axis of the beam has an effect, due to the Faraday effect, of rotation of the light polarization plane, characterized in that it comprises: a first step of inducing within the layer of ferrimagnetic material and along the axis of the light beam a magnetic alternating modulation field having an amplitude exceeding the saturation limit of the layer (3) of ferrimagnetic material, during a sufficient time corresponding to a stabilizing time at the end of which a coherent oscillation of the magnetization within the layer of ferrimagnetic material must be established, said oscillation causing the occurrence of an oscillation of the plane of polarization of the light beam which is symmetrical with respect to said determined plane; and a second step comprising the following operations which are performed simultaneously:

progressive reduction of the intensity of the modulation field,

detection of any dissymmetry of the oscillation of the plane of polarization of the light beam with respect to said determined plane,

inducing a continuous magnetic field corresponding to the performed detection along the axis of the light beam to restore the symmetry of oscillation, and permitting to obtain a value of the magnetic field to be measured.

2. Measurement system using the method of claim 1, comprising a measurement cell which in turn comprises: a transmission device (1) permitting to emit a light beam (F1) which is linearly polarized and which propagates along a determined axis of propagation; a plate of magnetic material (3) aligned along the axis of the light beam and permitting inside of it a guided propagation of the beam as well as a rotation of the direction of polarization of the beam during its propagation; an analyzer (4); means (5) for detecting the rotation of polarization associated with the plate (3) along the axis of the light beam, receiving the beam after it has cross the associated plate, and supplying a polarization rotation measurement signal (CR1); and a solenoid (12) located around the plate in a manner to be able to induce a magnetic field along the axis of the light beam, characterized in that it comprises control and supply circuits (11, 13, 14) permitting during a time corresponding to the first step to supply said solenoid with an alternating current of high amplitude in such a manner that the induced field saturates the plate (3), and then during a time corresponding to the second step, to progressively reduce the level of the alternating current supplied to the solenoid (12), and to supply simultaneously to it a feedback direct current in dependence upon the polarization rotation measurement signal (CR1) supplied by the

detection means (5, 10 and 15) to permit the compensation of a continuous magnetic field existing along the axis of the beam.

3. Measurement system according to claim 2, characterized in that the control and supply circuits comprise: a supply circuit (11) having first, second and third control inputs (E34, E35, E36) and permitting to supply current to the solenoid (12) by first outputs (E30, E31) and second outputs (E32, E33) according to signals received on its three inputs; a gate circuit (14) connected to the third input (E36) of the supply circuit and permitting to transmit therethrough a polarization rotation measurement signal (CR2) received from the detection means (5, 10, 15); a time base circuit (13) connected to the first and second inputs (E34, E35) of the supply circuit (11) as well as to the gate circuit (14) and supplying during a determined time corresponding to the first step a first signal (t1) to the first input (E34) of the supply circuit (11) to control by its first outputs (E30, E31) the supply of the solenoid (12) with an alternating modulation current of high amplitude, and then during a time corresponding to the second step a second signal (t2), said second signal being supplied, on the one hand, to the second input (E35) of the supply circuit (11) and controlling the progressive reduction of the alternating modulation current, and, on the other hand, to the gate circuit (14) in a manner to make it conductive and to permit the transmission of the polarization rotation measurement signal (CR1) to the third input (E36) of the supply circuit (11) to control thereby and by its second outputs (E32, E33) the supply of the solenoid (12) with a feedback current inducing a magnetic field balancing the effect of the magnetic field to be measured.

4. Measurement cell according to any of claims 2 to 3, characterized in that the layer of ferrimagnetic material (3) has an elongated shape and is arranged in such a manner that the light beam (F1) crosses it along its small dimension, the demagnetizing field being then perpendicular to the direction of the light beam.

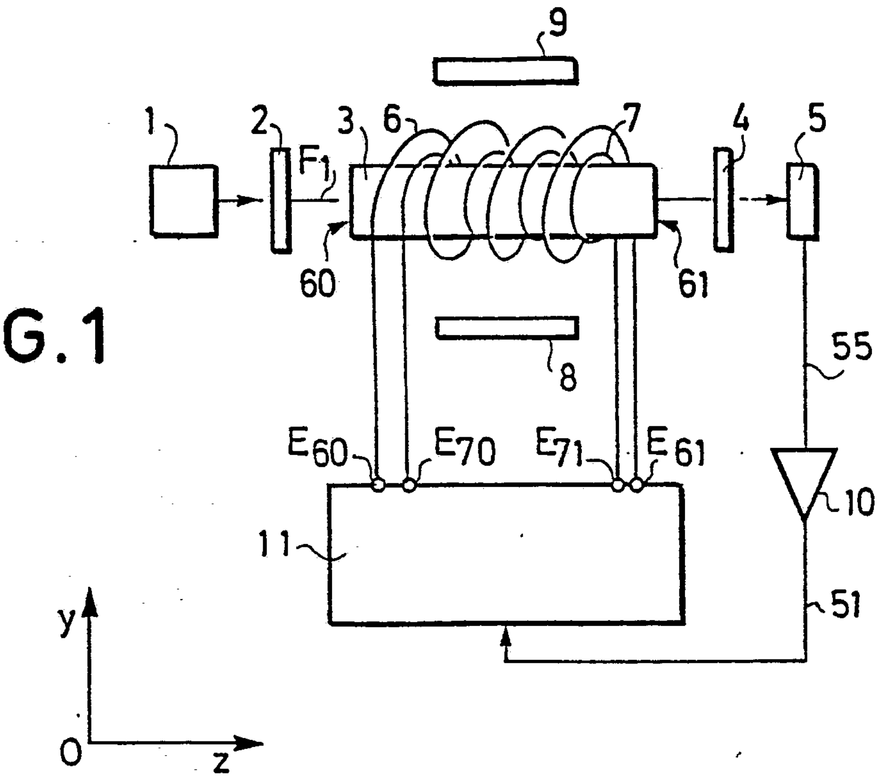
1
2
F1
3
6
7
4
5
9
60
61
8
55
E60
E70
E71
E61
10
11
51
y
O
z

FIG.1

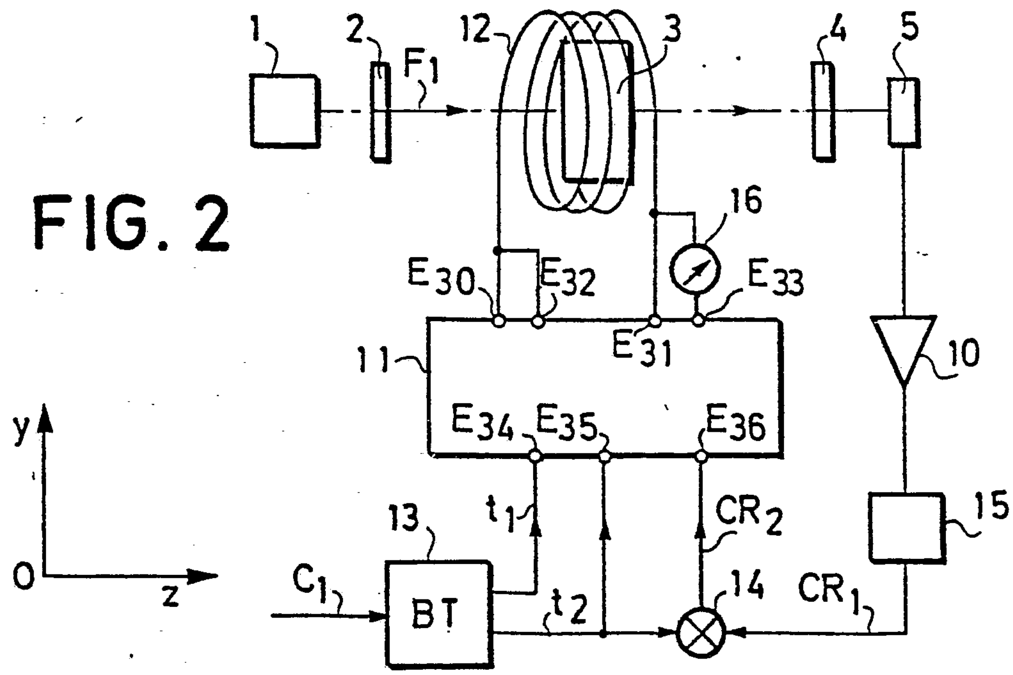
1
2
F1
12
3
4
5
16
E30
E32
E33
E31
11
10
E34
E35
E36
y
O
z
13
t1
CR2
15
C1
BT
t2
14
CR1

FIG. 2

FIG. 3